(19) Europäisches Patentamt
European Patent Office
Office européen des brevets

(11) **EP 1 826 773 B1**

(12) **EUROPEAN PATENT SPECIFICATION**

(45) Date of publication and mention
of the grant of the patent:
**03.06.2009 Bulletin 2009/23**

(51) Int Cl.:
***G11C 11/15*** *(2006.01)*        ***G11C 11/16*** *(2006.01)*

(21) Application number: **06123193.2**

(22) Date of filing: **30.10.2006**

(54) **Magnetic memory device using magnetic domain motion**

Magnetspeichervorrichtung unter Verwendung der Bewegung magnetischer Domänen

Dispositif de mémoire magnétique utilisant un mouvement de domaine magnétique

(84) Designated Contracting States:
**DE FR GB**

(30) Priority: **22.02.2006 KR 20060017238**

(43) Date of publication of application:
**29.08.2007 Bulletin 2007/35**

(73) Proprietor: **Samsung Electronics Co., Ltd.**
**Suwon-si, Gyeonggi-Do (KR)**

(72) Inventors:
 • **Kim, Tae-wan**
  **Yongin-si**
  **Gyeonggi-do (KR)**
 • **Cho, Young-jin**
  **Yeongtong-gu**
  **Suwon-si**
  **Gyeonggi-do (KR)**
 • **Kim, Kee-won**
  **Samsung Advanced Inst. of Technology**
  **Gyeonggi-do (KR)**
 • **Hwang, In-jun**
  **Samsung Advanced Inst. of Technology**
  **Gyeonggi-do (KR)**

(74) Representative: **Greene, Simon Kenneth**
**Elkington and Fife LLP**
**Prospect House**
**8 Pembroke Road**
**Sevenoaks,**
**Kent TN13 1XR (GB)**

(56) References cited:
**EP-A- 1 701 357**        **EP-A2- 1 320 102**
**US-A1- 2004 251 232**        **US-A1- 2004 257 719**

 • **CHUN BYONG ET AL: "Magnetization switching and tunneling magnetoresistance effects of synthetic antiferromagnet free layers consisting of amorphous NiFeSiB" APPLIED PHYSICS LETTERS, AIP, AMERICAN INSTITUTE OF PHYSICS, MELVILLE, NY, US, vol. 87, no. 8, 18 August 2005 (2005-08-18), pages 82508-82508, XP012077548 ISSN: 0003-6951**

**Description**

The present invention relates to a magnetic memory device, and more particularly, to a magnetic memory device where data bits each consisting of a magnetic domain can be stored in an array and a magnetic domain motion is possible.

A magnetic random access memory (MRAM) is one of non-volatile magnetic memories and a new solid state magnetic memory that uses magnetic resistance effect based on spin-dependent conduction peculiar to a nano magnetic material. That is, the MRAM uses giant magnetoresistance (GMR) or tunnel magnetoresistance (TMR) generated as spin, which is a degree of freedom of an electron, has a great influence on electron delivery.

The GMR is a resistance difference generated when ferromagnetic materials located with a non-magnetic material interposed therebetween have the same magnetization direction or different magnetization directions in an adjoining arrangement of ferromagnetic material/ metallic non-magnetic material/ferromagnetic material. The TMR is resistance where a current easily flows through when two ferromagnetic materials have the same magnetization direction in an adjoining arrangement of ferromagnetic material/ insulator/ ferromagnetic material compared to when the two ferromagnetic materials have different magnetization directions. Since the MRAM using the GMR has a relatively small resistance difference caused by a magnetization direction, a large voltage difference cannot be achieved. Also, since the MRAM has a disadvantage that a size of a metal oxide semiconductor field effect transistor (MOSFET) that is combined with a GMR layer in order to form a cell should increase, a research for pursuing commercialization of the MRAM using the TMR layer is currently carried out more actively.

The MRAM may consist of a transistor, which is a switching device, and a magnetic tunnel junction (MTJ) cell in which data is stored. Generally, the MTJ cell may consist of a pinned ferromagnetic layer having a pinned magnetization direction, a free ferromagnetic layer whose magnetization direction may be parallel or anti-parallel to the pinned magnetization direction of the pinned ferromagnetic layer, and a non-magnetic layer located between the pinned ferromagnetic layer and the free ferromagnetic lawyer, and magnetically separating the ferromagnetic layers.

However, since the MTJ stores one-bit data per cell, there is a limitation in increasing data storage capacity of the MRAM. Therefore, a new storage technology is required in order to increase an information storage capacity of a magnetic memory such as the MRAM.

US 2004/0251232 discloses a magnetic memory device as indicated in the preamble of claim 1. It describes a magnetic data track in which data is stored in a plurality of pinned magnetic domain walls along a track. A writing device is provided at a location along the track.

Chun et al, "Magnetization switching and tunnelling magnetoresistance effects of synthetic antiferromagnetic free layers consisting of amorphous NiFeSiB", Applied Physics Letters, volume 87, document 082508 (2005), describes a material for magnetic tunnelling junctions, specifically NiFeSiB.

SUMMARY OF THE INVENTION

According to an aspect of the present invention, there is provided a magnetic memory device according to claim 1.

The present invention provides a magnetic memory device having a memory track where a plurality of magnetic domains are formed so that data bits can be stored in an array, and a magnetic domain motion is easily performed.

The memory track may be formed of NiFe group IV element alloy, e.g., NiFeSiB.

The non-magnetic layer may be one of a conduction layer and an insulation layer serving as a tunneling barrier.

The memory track may include: at least one data storage region having data bit regions corresponding to the number of data bits to be stored and storing a plurality of data bits; and a buffer region that adjoins the data storage region and storing, as necessary, data moved to the outside of the data storage region during a magnetic domain motion.

The memory device may further include a second input portion electrically connected to at least one of the data bit regions of the memory track, and the reference layer, and inputting at least one of a writing current signal and a reading current signal.

The memory track may include a plurality of data storage regions, a buffer region is located between two adjacent data storage regions, and at least one second input portion is formed per data storage region.

BRIEF DESCRIPTION OF THE DRAWINGS

The above and other features and advantages of the present invention will become more apparent by describing in detail exemplary embodiments thereof with reference to the attached drawings in which:

FIG. 1 is a schematic view of a magnetic memory device according to the present invention;
FIG. 2 is a view illustrating a magnetic hysteresis curve of NiFe which is a soft magnetic material;
FIG. 3 is a view illustrating a magnetic hysteresis curve of NiFeSiB which is an amorphous soft magnetic material;

FIG. 4 is a schematic view illustrating a magnetic memory device according to an embodiment of the present invention;

FIGS. 5A through 5C are views illustrating a switching current is applied to a third data bit region (a specific data bit region) of FIG. 4 so that a magnetization direction of the third data bit region is reversed, and the reversed magnetization direction of the third data bit region is moved to an adjacent fourth data bit region D4 by a motion current;

FIGS. 6A and 6B are views illustrating a reading current is applied to a third data bit region (a specific data bit region) so that data of the third data bit region is read, and the magnetization direction of the third data bit region is moved to an adjacent fourth data bit region by a motion current;

FIG. 7 is a schematic graph illustrating a magnetic domain motion current pulse 1, a reading current pulse 2, a writing current pulse 2 that are applied to a magnetic memory device according to the present invention; and

FIG. 8 is a schematic view of a magnetic memory device according to another embodiment of the present invention.

## DETAILED DESCRIPTION OF THE INVENTION

The present invention will now be described more fully with reference to the accompanying drawings, in which exemplary embodiments of the invention are shown.

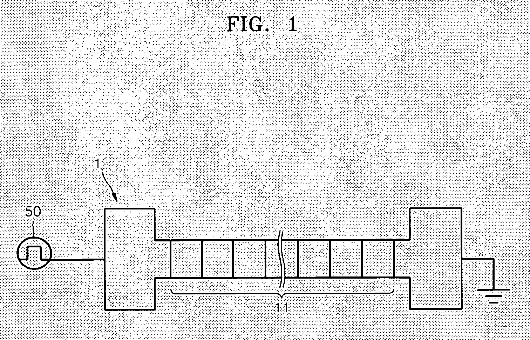

FIG. 1 is a schematic view of a magnetic memory device according to the present invention.

Referring to FIG. 1, the magnetic memory device 1 includes a memory track 11 where a plurality of magnetic domains are formed so that a data bit consisting of the magnetic domains can be stored in an array. Also, the magnetic memory device 1 may further include a first input portion 50 electrically connected to the memory track 11 and inputting a magnetic domain motion signal.

Magnetic domain walls may be formed in the memory track 11. A plurality of magnetic domains are formed in the memory track 11 by these magnetic domain walls.

Magnetization directions of the memory track 11 may be switchable so that data is recorded on the memory track 11. In this case, the magnetic memory device 1 may record a data bit (set by magnetization direction) on a magnetic domain. Here, the magnetic memory device 1 according to the present invention, as described in an embodiment below, may be formed to record a data bit, i.e., "0" or "1" by reversing magnetization direction of a magnetic domain of the memory track 11 using spin transfer torque, that is, current induced magnetic switching (CIMS). For another example, a magnetic memory device 1 according to the present invention may be formed to record a data bit by reversing a magnetization direction of a magnetic domain using a magnetic field induced to a magnetic track 11 by a current.

The memory track 11 may be formed of an amorphous soft magnetic material having a large magnetic anisotropy constant Ku so that a magnetic domain motion is easily performed.

Since NiFe, which is a general soft magnetic material, has a relatively small magnetic anisotropy constant, a high current is required for a magnetic domain motion when a memory track capable of being formed a plurality of magnetic domains using NiFe is formed.

Therefore, the memory track 11 may be formed of an amorphous soft magnetic material having a larger magnetic anisotropy constant Ku than that of NiFe. For example, the memory track 11 may be formed of NiFe group IV element alloy having a large magnetic anisotropy constant such as NiFeSiB.

Since an amorphous soft magnetic material of NiFe group IV element alloy such as NiFeSiB has a high anisotropy magnetic field Hk, magnetic anisotropy is easily formed.

When a current required for a magnetic domain motion is high, a possibility that a magnetic material is cut off in its intermediate portion by an applied current for a magnetic domain motion is high. Therefore, to form a domain motion memory track 11, it is needed to form the memory track 11 using a material where a magnetic domain motion is easily performed even by application of a low current.

When a domain wall width is reduced, a magnetic domain motion may be realized even with small energy (current). The domain wall width W is in proportion to surface energy of domain wall Γ of a domain wall as shown in Equation 1.

$$\Gamma \propto W \quad \text{..............................................................................} \text{Equation 1}$$

Also, a width of a domain wall is in proportion to a square root of a magnetic anisotropy constant Ku as shown in Equation 2.

$$W \propto (K_u)^{\frac{1}{2}} \quad \text{...............................................................} \text{Equation 2}$$

As is revealed from Equations 1 and 2, a material having a large magnetic anisotropy constant needs to be used for forming the memory track 11 in order to reduce the width of the domain wall and thus energy, i.e., a current for a magnetic domain motion.

Therefore, when the memory track 11 is formed of an amorphous soft magnetic material having a large magnetic anisotropy, a magnetic domain motion may be easily performed even with a small current, and cutting off of the magnetic material may be prevented.

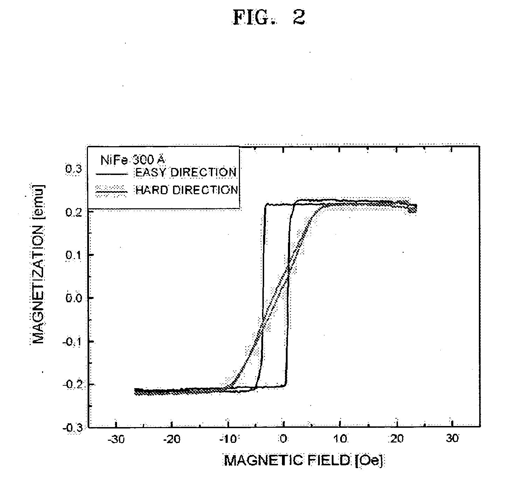

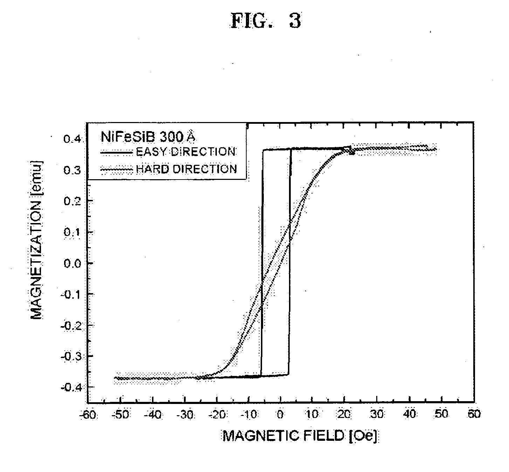

FIG. 2 is a view illustrating a magnetic hysteresis curve of NiFe which is a soft magnetic material, and FIG. 3 is a view illustrating a magnetic hysteresis curve of NiFeSiB which is an amorphous soft magnetic material. In detail, FIG. 2 shows a hysteresis curve of $Ni_{81}Fe_{19}$, and FIG. 3 shows a hysteresis curve of $Ni_{16}Fe_{62}Si_8B_{14}$. Each of FIGS. 2 and 3 show a hysteresis curve when a magnetic field is applied in an easy direction and a hysteresis curve when a magnetic field is applied in a hard direction.

Examination of FIGS. 2 and 3 shows that coercivity (Hc) of NiFe is about 10 0e, and coercivity Hc of NiFeSiB is about 20 0e. Accordingly, the coercivity Hc of NiFeSiB, which is an amorphous soft magnetic material is about two times greater than the coercivity Hc of NiFe. Therefore, induced magnetic anisotropy of NiFeSiB is two or more times greater than that of general NiFe.

Here, a magnetic domain anisotropy magnetic field Hk is in proportion to coercivity Hc and a magnetic anisotropy constant Ku. Therefore, the magnetic anisotropy constant is in proportion to coercivity.

Therefore, when an amorphous soft magnetic material such as NiFeSiB having high coercivity and high magnetic anisotropy is used, stable bit formation may be achieved, a strip magnetic domain may be formed. Accordingly, a data bit consisting of a magnetic domain is stored in an array, and a width of a domain wall is reduced, so that a magnetic domain motion may be realized even with a low current, and thus a magnetic domain motion may be easily performed. Therefore, since a magnetic domain motion is performed with a low current in the memory track 11 formed of an amorphous soft magnetic material, cutting off of the magnetic material may be prevented.

Therefore, when the memory track 11 is formed of an amorphous soft magnetic material of NiFe group IV element alloy such as NiFeSiB, a magnetic memory 1 where a data bit consisting of a magnetic domain may be stored in an array, and a magnetic domain motion may be easily performed, may be realized.

On the other hand, the first input portion 50 is electrically connected to the memory track 11 in order to move a magnetic domain of the memory track 11 and thus move data (i.e., in-plane magnetization or perpendicular magnetization) stored in a data bit region to an adjacent data bit region. A magnetization direction of a magnetic domain is moved to an adjoining magnetic domain according to a motion signal input, i.e., a motion current signal input through the first input portion 50. Such motion is called a magnetic domain motion.

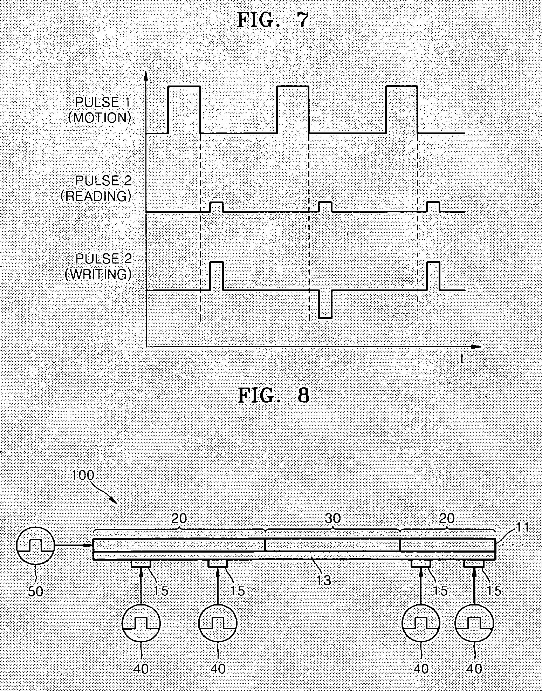

The motion signal may be a pulse current (Pulse 1) input by a constant period as illustrated in FIG. 7. The motion signal may be input such that the magnetic domain motion is performed by a data bit region unit that includes a single magnetic domain. Here, since the magnetic domain motion is to substantially move a magnetization direction of a predetermined magnetic domain to an adjoining magnetic domain, the motion signal may be continuously applied while the magnetic domain motion is performed by a data bit region unit, and periodically applied such that the magnetic domain motion is performed by a data bit region unit.

According to the above-described magnetic memory 1, the memory track 11 where a plurality of magnetic domains may be formed, and respective data bits consisting of a single magnetic domain may be stored in an array, is provided, so that a plurality of data bits may be stored per memory track 11 and thus information storage capacity of the magnetic memory 1 may be remarkably increased. Also, since the magnetic domain of the memory track 11 may be easily moved using a low applied current, it is possible to read or write a plurality of data bits on the memory track 11 by performing in turns a data reading or data wiring operation and the magnetic domain motion as described below.

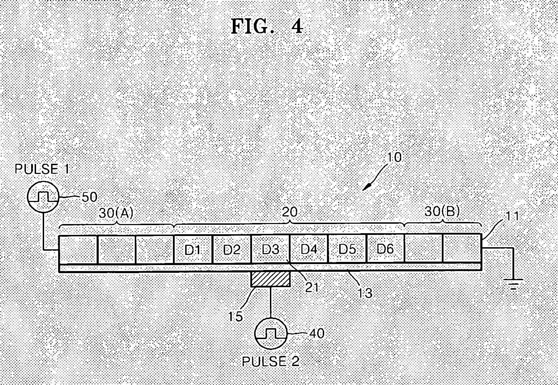

FIG. 4 is a schematic view illustrating a magnetic memory device according to an embodiment of the present invention, where the magnetic memory device records a data bit, i.e., "0" or "1" by reversing a magnetization direction of a magnetic domain of the memory track 11 using spin transfer torque. In FIG. 4, since the memory track 11 and the first input portion 50 are the substantially the same members as those of FIG. 1, the same reference numerals are used and detailed description thereof will be omitted.

Referring to FIG. 4, the magnetic memory device 10 includes a memory track 11; a first input portion 50 inputting a magnetic domain motion signal for the memory track 11; a reference layer 15 formed corresponding to a portion of the memory track 11 and having a pinned magnetization direction. A data bit consisting of a magnetic domain corresponding to an effective size of the reference layer 15 can be stored in an array on the memory track 11. The magnetic memory device 10 further includes a second input portion 40 electrically connected to at least one data bit region of the memory track 11 and a reference layer 15 and inputting at least one (Pulse 2) of a writing current signal and a reading current signal. A non-magnetic layer 13 may be located between the reference layer 15 and the memory track 11. In FIG. 4, though the non-magnetic layer 13 is formed over an entire surface of the memory track 11, the non-magnetic layer 13 may be formed on an upper surface of the reference layer 15.

As described above, the memory track 11 may include a strip of the plurality of magnetic domains, so that a data bit consisting of a single magnetic domain can be stored in an array. Also, the memory track 11 may be formed of an amorphous soft magnetic material such as NiFeSiB, so that a magnetic domain motion can be performed even with a low current.

In the present embodiment, the memory track 11 may be a recording layer whose magnetization direction may be switched and on which a data bit is stored.

The reference layer 15 is a pinned layer whose magnetization direction is pinned and is formed to have an effective size corresponding to one data bit region (one magnetic domain) of the memory track 11.

On the other hand, the non-magnetic layer 13 located between the memory track 11 and the reference layer 15 may be one of a conduction layer such as Cu and an insulation layer such as an aluminum oxide layer serving as a tunneling barrier.

In the magnetic memory 10 according to an embodiment of the present invention, a data writing operation or a stored data reading operation may be performed by an area unit of the memory track 11 that corresponds to an effective size of the reference layer 15. Therefore, the effective size of the reference layer 15 substantially determines a size of one data bit region (i.e., a magnetic domain) of the memory track 11.

Since it is preferable that only a single magnetic domain is present within one data bit region, a magnetic domain formed in the memory track 11 may be formed in at least a size corresponding to the effective size of the reference layer 15.

Also, the memory track 11 may be formed at a length long an much as a multiple of the number of data bit regions that corresponds to the effective size of the reference layer 15, that is, a width of a magnetic domain motion. Accordingly, an array of a plurality of data bit regions each region consisting of a single magnetic domain is provided by a unit of an effective size of the reference layer 19, so that the memory track 11 where a plurality of data bits can be stored in an array is obtained.

Referring to FIG. 4, the memory track 11 includes: a data storage region 20 having data bit regions D1, D2, D3, D4, D5, and D6 corresponding to the number of data bits to be stored, and storing a plurality of data bits; and a buffer region 30 adjoining the data storage region 20 and storing, if necessary, data moved to the outside of the data storage region 20 during a magnetic domain motion. The buffer region 30 may be located at least one side of the data storage region 20.

When the data storage region 20 has n data bit regions, the buffer region 30 may have at least n or n-1 data bit regions. That is, the number of the data bit regions contained in the buffer region 30 may be formed as many as at least the same number of the data bit regions contained in the data storage region 20 or a small number about 1 less than the number of the data bit regions of the data storage region 20. FIG. 4 shows an example where a central portion of the memory track 11 is used as the data storage region 20 and both edge portions of the memory track 11 are used as the buffer region 30. Since a writing or reading operation is not directly performed on the buffer region 30, the buffer region 30 may include only the memory track 11, which is a recording layer, or include a layer structure consisting of the memory track 11 and the non-magnetic layer 13 located beneath it. Also, in the magnetic memory device 10 according to an embodiment of the present invention, the buffer region 30 may have substantially the same layer structure as that of the data storage region 20, that is, a layer structure that includes even the reference layer 15 with a signal not input to the reference layer 15 of the buffer region 30.

In FIG. 4, a data writing or reading operation is performed on a third data bit region D3, which is a third region of six data bit regions D1, D2, D3, D4, D5, and D6 of the data storage region 20, and a first portion A and a second portion B of the buffer region 30 are provided on both edges of the data storage region 20. FIG. 4 shows that the first portion A of the buffer region 30 having three data bit regions on the left side of the data storage region 20, and the second portion B of the buffer region 30 having two data bit regions on the right side of the data storage region 20 are formed with consideration of the case where a magnetic domain motion is performed from left to right during a data reading operation. For data contained in six data bit regions D1, D2, D3, D4, D5, and D6 of the data storage region 20, a data reading operation starts with the sixth data bit region D6 moved to the left such that data of the sixth data bit region D6 is positioned at a third data bit region D3, and a motion operation and a reading operation are performed in turns while the data is moved to the right, so that the data contained in the six data bit regions D1, D2, D3, D4, D5, and D6 can be sequentially read.

Though FIG. 4 shows an example where the reference layer 15 is formed on a middle portion of the data storage region 20 and thus a data writing or reading operation is performed on the middle portion of the data storage region 20, the present invention is not limited to this particular example and various modifications can be made.

For example, a data writing or reading operation is performed on a first data bit region D1 of the data storage region 20, and the buffer region 30 having at least the same number of the data bit regions contained in the data storage region 20 or a small number 1 less than the number of the data bit regions may be formed adjacently to a data bit region of the data storage region 20 where the data writing or reading operation starts (for example, when the data writing or reading operation starts at a first data bit region D1 or a six data bit region D6, the left side of the first data bit region D1 or the right side of the six data bit region D6) or may be formed at both edges of the data storage region 20. Since this modification can be easily deduced from the structure shown in FIG. 4, detailed illustration thereof will be omitted.

When the buffer region 30 is formed only on the right or left of the data storage region 20, data contained in the data storage region 20 is moved to the buffer region 30, and then the data reading operation can be performed. At this point, a magnetic domain motion performed during the data reading operation and a magnetic domain motion performed during the data writing operation may be performed in the same direction. Also, the data reading operation may be simultaneously performed while data contained in the data storage region 20 is moved to the buffer region 30. In this case, a magnetic domain motion performed during the data reading operation and a magnetic domain motion performed during the data writing operation are performed in mutually opposite directions.

When n data bits are stored in the data storage region 20, the number of data bit regions of the buffer region 30 may be one-bit region smaller than that of the data storage region 20. That is, the buffer region 30 may be formed to store (n-1) data bits. Since one-data bit can be always stored on a data bit region, i.e., a specific data bit region 21 of the data storage region 20 where the data writing or reading operation is performed, it is necessary that the buffer region 30 temporarily stores only (n-1) data bits. Here, the buffer region 30 may have the same number as the data bit regions or larger number of the data bit regions of the data storage region 20, of course.

When the buffer regions 30 are formed on both sides of the data storage region 20, data contained in the data storage region 20 can be read while a magnetic domain motion is performed without a process of moving the data to the buffer region 30. At this point, a magnetic domain motion performed during the data reading operation and a magnetic domain motion performed during the data writing operation are performed in mutually opposite directions. Even in this case, when n data bits are stored on the data storage region 20, the number of data bit regions of the buffer regions 30 formed on both sides of the data storage region 20 may be one-bit region smaller than that of the data storage region 20.

On the other hand, though the memory track 11 of the magnetic memory device 10 has the buffer region 30 adjoining the data storage region 20 in the above descriptions, the memory track 11 may consist of the data storage region 20 only without the buffer region 30. At this point, the data storage region 20 further includes redundant data bit regions serving as a buffer in addition to the data bit regions of the number of bits to be stored. For example, when n data bits are to be stored, the data storage region 20 may include at least 2n or 2n-1 data bit regions.

On the other hand, in the magnetic memory device 10 according to an embodiment of the present invention, an adjoining magnetic domain of the memory track 11 is moved and a data bit, i.e., "0" or "1" is recorded on a predetermined magnetic domain, by reversing a magnetization direction of one of the magnetic domains, i.e., the predetermined magnetic domain located at a predetermined position corresponding to the reference layer 15 using spin transfer torque, i.e., current induced magnetic switching (CIMS), according to a magnetic domain motion signal (Pulse 1) applied from the first input portion 50, and a writing current signal (e.g., Pulse 2 (writing) in FIG. 7) applied, in synchronization with this magnetic domain motion signal (Pulse 1), from the second input portion 40.

Additionally, in the magnetic memory device 10 according to an embodiment of the present invention, a magnetic domain is moved, and data stored on a magnetic domain of a memory track 11 is read by applying a reading signal, i.e., a reading pulse signal (e.g., using spin tunnelling) between the memory track 11, which is a recording layer, and the reference layer 15, according to a magnetic domain motion signal (Pulse 1) applied from the first input portion 50, and a reading signal (e.g., Pulse 2 (reading) in FIG. 7) applied, in synchronization with this motion signal (Pulse 1), from the second input portion 40.

In FIG. 4, Pulse 1 is a magnetic domain motion signal and Pulse 2 is a writing signal or reading signal.

On the other hand, the second input portion 40 is electrically connected to the memory track 11 and the reference layer 15. FIG. 4 shows that the second input portion 40 is electrically connected to the reference layer 15 and a predetermined data bit region 21 of the memory track 11 that is located on the reference layer 15.

A writing signal is input to the predetermined data bit region 21 of the memory track 11 and the reference layer 15 through the second input portion 40, and a magnetization direction of the predetermined data bit region 21 of the memory track 11 that is located on the reference layer 15 is determined according to this writing signal. In FIG. 4, the data storage region 20 has an array of first to sixth data bit regions D1, D2, D3, D4, D5, and D6, and the predetermined data bit region 21 electrically connected to the second input portion 40 becomes the third data bit region D3 located on the reference layer 15.

When a writing signal is input through the second input portion 40, a magnetization direction of the third data bit region D3 is determined according to this writing signal. For example, when the third data bit region D3 has a predetermined magnetization direction, the magnetization direction of the third data bit region D3 is reversed or maintains an original magnetization direction depending on an applied writing signal. The magnetization direction determined in this manner represents a recorded data bit.

Referring to FIG. 7, the writing signal is a pulse-type switching current. A magnetization direction of a predetermined data bit region 21, e.g., the third data bit region D3 of the memory track 11 that is located on the reference layer 15 is selectively switched depending on polarity of this switching current, and a data bit to be stored, i.e., "0" or "1" is stored on the predetermined data bit region 21.

For example, assuming that the reference layer 15 has a predetermined magnetization direction and a data bit is determined as "0" when a magnetization direction of a predetermined data bit region 21 becomes the same as, i.e., parallel to that of the reference layer 15 by application of a switching current, a data bit may be determined as "1" when the predetermined data bit region 21 has a magnetization direction opposite to that of the reference layer 15 by application of a switching current having an opposite polarity. Consequently, a data is stored by changing the switching current's polarity to allow the magnetization direction of the predetermined data bit region 21 to be the same as that of the reference layer 15 or to be opposite to that of the reference layer 15.

Here, the magnetization direction of the reference layer 19 is determined in advance. Therefore, assuming that a data bit is "0" when the magnetization direction of the predetermined data bit region 21 of the memory track 11 is parallel to that of the magnetization direction of the reference layer 15 determined in advance, and a data bit is "1" when the magnetization direction of the predetermined data bit region 21 is anti-parallel to that of the magnetization direction of the reference layer 15, desired data may be stored using switching of the magnetization direction of the predetermined data bit region 21 of the memory track 11.

On the other hand, when stored data is to be read, a reading signal, e.g., a reading pulse current illustrated in FIG. 7 is input to the predetermined data bit region 21 of the memory track 11 and the reference layer 15 through the second input portion 40. At this point, the reference layer 15, the predetermined data bit region 21 of the memory track 11 that is located on the reference layer 15, and the non magnetic layer 13 located therebetween constitute a magnetic tunnel junction (MTJ) cell. Therefore, passing value of a current or resistance changes depending on a magnetization direction of a predetermined data bit region 21 of the memory track 11 with respect to the magnetization direction of the reference layer 15. Data is read using such a change. Here, a separate reference layer and input portion may be provided in order to read data.

Referring to FIG. 7, the reading pulse current may be a pulse current smaller than the switching current for writing. This reading pulse current is applied in synchronization with the domain motion signal. Therefore, stored data may be read using a magnetic domain motion and a magnetization direction of a predetermined data bit region 21 located on the reference layer 15.

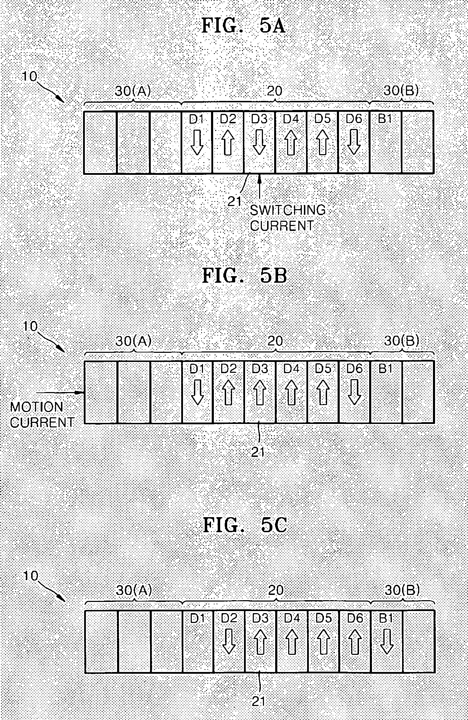

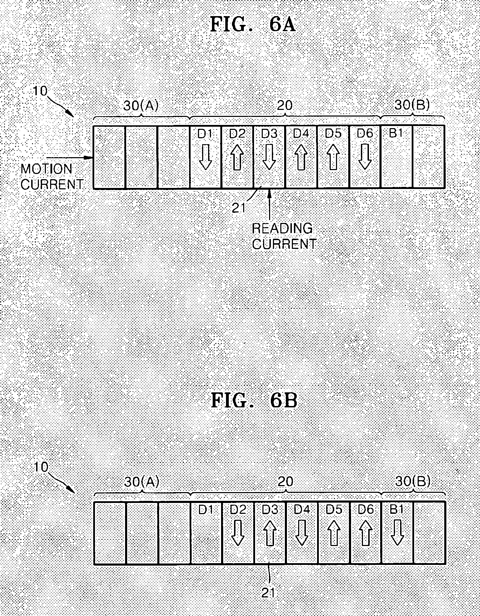

In the magnetic memory device 10 having the above-described structure according to the present invention, inputting of a writing switching current or reading switching current, and inputting of a motion signal may be performed in turns. Therefore, a data writing operation or stored data reading operation, and a magnetic domain motion are performed in turns, so that a plurality of data bits are sequentially recorded on a plurality of data bit regions, or a plurality of data bits stored on the plurality of data bit regions are sequentially read. A data writing operation or data reading operation in the memory track 10 according to an embodiment of the present invention will be described below with reference to FIGS. 5A through 5C, and 6A and 6B.

FIGS. 5A through 5C are views illustrating a switching current is applied to a third data bit region D3 (a predetermined data bit region 21) of FIG. 4 so that a magnetization direction of the third data bit region D3 is reversed, and the reversed magnetization direction of the third data bit region D3 is moved to an adjoining fourth adjoining data bit region D4 by a motion current. FIGS. 6A and 6B are views illustrating a reading current is applied to a third data bit region D3 (a predetermined data bit region 21) so that data of the third data bit region D3 is read, and the magnetization direction of the third data bit region D3 is moved to an adjoining fourth adjoining data bit region D4 by a motion current. FIG. 7 is a schematic graph illustrating a magnetic domain motion current pulse 1, a reading current pulse 2, a writing current pulse 2 that are applied to a magnetic memory device 10 according to the present invention. In FIG. 7, a horizontal axis is a time axis t.

The data writing operation is performed in the following manner. When a switching current is applied to a third data bit region D3 as illustrated in FIG. 5A, a magnetization direction of the third data bit region D3 is reversed as illustrated in FIG. 5B. After that, when a motion current is applied to the memory track 11, magnetization directions of respective data bit regions are moved to adjoining data bit regions, respectively, as illustrated in FIG. 5C. That is, magnetization directions of first to sixth data bit regions D1, D2, D3, D4, D5, and D6 of the data storage region 20 illustrated in FIG. 5B. are moved, by one-data bit region, to the second to sixth data bit regions D2, D3, D4, D5, D6 and a first data bit region B1 of a second portion B of the buffer region 30, respectively, as illustrated in FIG. 5C.

As described above, the magnetization direction of the predetermined data bit region 21 is determined, and data (magnetization direction) of the predetermined data bit region 21 is moved to the adjoining data bit region, i.e., a fourth data bit region D4 after a predetermined time elapses, and a writing signal is input again to the predetermined data bit region 21 to determine a magnetization direction again. Using a periodically applied motion current and a writing switching signal periodically applied in synchronization with the motion current illustrated in FIG. 7, such determining of a magnetization direction and the motion process are performed in turns, so that a plurality of data bits are recorded in an array on the plurality of data bit regions of the memory track 11. After the data recording operation is completed, a moved data storage position may be maintained or a motion signal moving the magnetic domains in the opposite direction is input, so that data stored on the first to sixth data bit regions D1, D2, D3, D4, D5, and D6 of the data storage region 20 is maintained.

The stored data reading operation is performed in the following manner. Referring to FIG. 6A, a reading current is applied to the third data bit region D3 so that data of the third data bit region D3 is read. After that, when a motion current is applied to the memory track 11 as illustrated in FIG. 6B, magnetization directions of respective data bit regions are moved to adjoining data bit regions, respectively. That is, magnetization directions of the first to sixth data bit regions D1, D2, D3, D4, D5, and D6 of the data storage region 20 illustrated in FIG. 6A. are moved, by one-data bit region, to the second to sixth data bit regions D2, D3, D4, D5, D6 and the first data bit region B1 of the second portion B of the buffer region 30, respectively, as illustrated in FIG. 6B.

As described above, the magnetization direction of the specific data bit region 21 is read, and data (magnetization direction) of the predetermined data bit region 21 is moved to the adjoining data bit region, i.e., the fourth data bit region D4 after a predetermined time elapses, and a reading signal is input again to the predetermined data bit region 21 to perform a data reading operation. Using a periodically applied motion current and a reading pulse signal (pulse current) periodically applied in synchronization with the motion current illustrated in FIG. 7, such reading of a magnetization direction and the motion process are performed in turns until reading of a plurality of data bits stored on the memory track 11 is completed. After the data reading operation is completed, a moved data storage position may be maintained or a motion signal moving the magnetic domains in the opposite direction is input, so that data stored on the first to sixth data bit regions D1, D2, D3, D4, D5, and D6 of the data storage region 20 is maintained.

During the reading operation, the reading pulse current is periodically applied in synchronization with a domain motion signal without polarity reversal as illustrated in FIG. 7. An amount of a current flowing through a tunnel barrier, and resistance thereof when the reading pulse current is applied to the reference layer 15 and the predetermined data bit regions 21 of the memory track 11, differ depending on whether a magnetization direction of the predetermined data bit region 21 of the memory track 11 is parallel to or anti-parallel to a magnetization direction of the reference layer 15. For example, resistance when the magnetization direction of the predetermined data bit region 21 of the memory track 11 is parallel to that of the reference layer 15 is smaller than resistance when the magnetization direction of the predetermined data bit region 21 is anti-parallel to the reference layer 15. Data stored in the predetermined data bit region 21 is recognized using such a resistance difference.

In the above descriptions, though a magnetic domain motion is performed by one data bit region unit, and the magnetic domain motion and the data bit writing or reading operation are performed in turns, those descriptions are provided for an exemplary purpose only and various modifications may be possible. For example, after a plurality of data bit regions are moved, the writing or reading operation may be performed.

FIG. 8 is a schematic view of a magnetic memory device 100 according to another embodiment of the present invention. Referring to FIG. 8, the magnetic memory device 100 may has a structure where a plurality of data storage regions 20 are provided to the memory track 11. At this point, the memory track 11 may further include a buffer region 30 that adjoins the data storage region 20 in order to store data moved to the outside of the data storage region 20 due to a magnetic domain motion. At this point, at least one second input portion 40 is formed per data storage region 20. When the plurality of data storage regions 20 are provided and at least one second input portion 40 corresponding to each of the data storage regions 20 is formed, a data storage capacity increases as many as the number of the data storage regions 20, and a data storing or reading speed that is the same or faster than that of the magnetic memory device 10 according to an embodiment of the present invention that includes the memory track 11 having a single data storage region consisting of a plurality of data bit regions, is accomplished.

FIG. 8 shows an example where a buffer region 30 is formed between two data storage regions 20. In the structure where a plurality of data storage regions 20 are formed, buffer regions 30 may be formed at least a position located before a first data storage region and a position located after a last data storage region, and a position located between two adjacent data storage regions.

Also, the example shown in FIG. 8 illustrates two reference layers 15 and two second input portions 40 are formed for one data storage region 20. When a plurality of second input portions 40 are formed for one data storage region 20, a data storing or reading speed may be enhanced even more.

For another embodiment, a magnetic memory device 100 may have a structure such that a plurality of reference layers 15 and second input portions 40 are formed for one data storage region 20 and inputting of a writing signal and a reading signal is performed through different second input portions 40. Also, the inputting of a wiring signal may be performed for a predetermined data storage region 20, and the inputting of a reading signal may be performed for another predetermined data storage region 20.

Also, in the above descriptions, the magnetic memory device according to the present invention can incorporate a magnetic device cable of reading a plurality of data bits (i.e., an MTJ or GMR sensor) and a recording magnetic device using spin transfer torque into a single device, but the present invention is not limited to this particular embodiment. That is, the magnetic memory device according to the present invention may be used as a magnetic device (i.e., an MTJ or GMR sensor) cable of reading a plurality of data bits using a magnetic domain motion, or may be also used as a recording magnetic device using spin transfer torque, capable of recording a plurality of data bits using the magnetic domain motion.

Also, in the above descriptions, the magnetic memory device according to the present invention performs a data writing operation using the spin transfer torque by directly applying a writing current signal to an MTJ cell consisting of the reference layer 15, the predetermined data bit region 21 of the memory track 11 that is located on the reference layer 15, and the non-magnetic layer 13 interposed therebetween, but the present invention is not limited to this particular embodiment.

That is, according to the magnetic memory device of the present invention, a data bit may be recorded by selectively reversing a magnetization direction of a magnetic domain of a predetermined data bit region of the memory track 11 using a magnetic field induced by a current. In this case, the magnetic memory device according to the present invention may include a structure generating a magnetic field for selectively reversing a magnetization direction of the predetermined data bit region of the memory track 11, and a FET for reading data stored in the memory track 11, instead of the second input portion 40 directly applying a writing or reading current signal to the memory track 11.

The magnetic memory device of the present invention has the memory track formed of an amorphous soft magnetic material having a high magnetic anisotropy constant and where a plurality of magnetic domains are formed, so that a magnetic domain motion can be easily performed even with a low current.

Also, since a data bit consisting of a magnetic domain can be stored in an array on the memory track, a plurality of data bits can be stored per cell to which the magnetic memory device of the present invention is applied, which remarkably increases a data storage capacity.

While the present invention has been particularly shown and described with reference to exemplary embodiments thereof, it will be understood by those of ordinary skill in the art that various changes in form and details may be made therein without departing from the scope of the present invention as defined by the following claims.

**Claims**

1. A magnetic memory device comprising:

   a memory track (11) where a plurality of magnetic domains (21) are formed so that a data bit consisting of a magnetic domain can be stored in an array, wherein a magnetization direction of the memory track is switchable;
   a reference layer (15) formed corresponding to a portion of the memory track and having a pinned magnetization direction; and
   a first input portion (50) electrically connected to the memory track and inputting a magnetic domain motion signal to move data stored on a data bit region of the memory track to an adjoining data bit region.
   **characterised in that**
   the memory track (11) is formed of an amorphous soft magnetic material having a larger magnetic anisotropy constant than that of the NiFe; and
   data bits consisting of the magnetic domains each corresponding to an effective size of the reference layer are stored in an array on the memory track.

2. The memory device of claim 1, wherein the memory track (11) is formed of NiFe group IV element alloy.

3. The memory device of claim 2, wherein the memory track (11) is formed of NiFeSiB.

4. The memory device of claim 1, wherein a non-magnetic layer (13) is further formed between the reference layer (15) and the memory track (11).

5. The memory device of claim 4, wherein the non-magnetic layer (13) is one of a conduction layer and an insulation layer serving as a tunneling barrier.

6. The memory device of claim 1, 4 or 5, wherein the memory track comprises:

   at least one a data storage region (20) having data bit regions corresponding to the number of data bits to be stored and storing a plurality of data bits; and
   a buffer region (30) that adjoins the data storage region and storing, as necessary, data moved to the outside of the data storage region during a magnetic domain motion.

7. The memory device of claim 6, further comprising a second input portion (40) electrically connected to at least one of the data bit regions of the memory track, and to the reference layer, and inputting at least one of a writing current signal and a reading current signal.

8. The memory device of claim 7, wherein the memory track comprises a plurality of data storage regions (20), a buffer region (30) is located between two adjacent data storage regions, and at least one second input portion is formed per data storage region.

9. The memory device of any claims 1 to 6, further comprising a second input portion (40) electrically connected to at least one of the data bit regions (20) of the memory track, and to the reference layer (15), and inputting at least one of a writing current signal and a reading current signal.

**Patentansprüche**

1. Magnetspeichergerät, das Folgendes umfasst:

   einen Speicher-Track (11), wo mehrere Magnetbereiche (21) ausgebildet sind, so dass ein Datenbit bestehend aus einem Magnetbereich in einem Array gespeichert werden kann, wobei eine Magnetisierungsrichtung des Speicher-Track umschaltbar ist;
   eine Referenzschicht (15), die entsprechend einem Abschnitt des Speicher-Tracks ausgebildet ist und eine fest verankerte (pinned) Magnetisierungsrichtung hat; und
   einen ersten Eingangsteil (50), der elektrisch mit dem Speicher-Track verbunden ist und ein Magnetbereichsbewegungssignal eingibt, um auf einer Datenbitregion des Speicher-Tracks gespeicherte Daten zu einer benachbarten Datenbitregion zu veschieben,
   **dadurch gekennzeichnet, dass**
   der Speicher-Track (11) aus einem amorphen weichmagnetischen Material mit einer größeren magnetischen Anisotropiekonstante als der des NiFe gebildet ist; und
   Datenbits, die aus den Magnetbereichen bestehen, die jeweils einer effektiven Größe der Referenzschicht entsprechen, in einem Array auf dem Speicher-Track gespeichert sind.

2. Speichergerät nach Anspruch 1, wobei der Speicher-Track (11) aus einer NiFe-Legierung von Elementen der Gruppe IV gebildet ist.

3. Speichergerät nach Anspruch 2, wobei der Speicher-Track (11) aus NiFeSiB gebildet ist.

4. Speichergerät nach Anspruch 1, wobei ferner eine nichtmagnetische Schicht (13) zwischen der Referenzschicht (15) und dem Speicher-Track (11) ausgebildet ist.

5. Speichergerät nach Anspruch 4, wobei die nichtmagnetische Schicht (13) eine Schicht aus einer leitenden Schicht und einer als Tunnelungsbarriere dienende Isolierschicht ist.

6. Speichergerät nach Anspruch 1, 4 oder 5, wobei der Speicher-Track Folgendes umfasst:

   wenigstens eine Datenspeicherregion (20) mit Datenbitregionen, die der Zahl der zu speichernden Datenbits entsprechen und die eine Mehrzahl von Datenbits speichern; und
   eine Pufferregion (30), die an die Datenspeicherregion angrenzt und nach Bedarf Daten speichert, die bei einer Bewegung des Magnetbereichs zur Außenseite der Datenspeicherregion verschoben werden.

7. Speichergerät nach Anspruch 6, das ferner einen zweiten Eingangsteil (40) umfasst, der elektrisch mit wenigstens einer der Datenbitregionen des Speicher-Tracks und mit der Referenzschicht verbunden ist und ein Schreibstromsignal und/oder ein Lesestromsignal eingibt.

8. Speichergerät nach Anspruch 7, wobei der Speicher-Track mehrere Datenspeicherregionen (20) umfasst, eine Pufferregion (30) sich zwischen zwei benachbarten Datenspeicherregionen befindet und wenigstens ein zweiter Eingangsteil pro Datenspeicherregion ausgebildet ist.

9. Speichergerät nach einem der Ansprüche 1 bis 6, das ferner einen zweiten Eingangsteil (40) umfasst, der mit wenigstens einer der Datenbitregionen (20) des Speicher-Tracks und mit der Referenzschicht (15) elektrisch verbunden ist und ein Schreibstromsignal und/oder ein Lesestromsignal eingibt.

**Revendications**

1. Dispositif de mémoire magnétique comprenant :

   une piste de mémoire (11) où sont formés une pluralité de domaines magnétiques (21) de sorte qu'un bit de données constitué d'un domaine magnétique puisse être stocké dans un réseau, dans lequel une direction de magnétisation de la piste de mémoire est commutable ;
   une couche de référence (15) formée correspondant à une partie de la piste de mémoire et ayant une direction de magnétisation fixée ; et
   une première partie d'entrée (50) connectée électriquement à la piste de mémoire et entrant un signal de mouvement de domaine magnétique pour déplacer les données stockées sur une zone de bit de données de la piste de mémoire à une zone de bits de données contiguë,
   **caractérisé en ce que**
   la piste de mémoire (11) est formée d'un matériau magnétique tendre amorphe ayant une constante d'anisotropie magnétique plus grande que celle du NiFe ; et
   les bits de données constitués des domaines magnétiques correspondant chacun à une taille effective de la couche de référence sont stockés dans un réseau sur la piste de mémoire.

2. Dispositif de mémoire selon la revendication 1, dans lequel la piste de mémoire (11) est formée d'alliage d'élément NiFe de groupe IV.

3. Dispositif de mémoire selon la revendication 2, dans lequel la piste de mémoire (11) est formée de NiFeSiB.

4. Dispositif de mémoire selon la revendication 1, dans lequel une couche non magnétique (13) est en outre formée entre la couche de référence (15) et la piste de mémoire (11).

5. Dispositif de mémoire selon la revendication 4, dans lequel la couche non magnétique (13) est soit une couche de conduction soit une couche d'isolation servant de barrière tunnel.

6. Dispositif de mémoire selon la revendication 1, 4 ou 5, dans lequel la piste de mémoire comprend :

   au moins une zone de stockage de données (20) ayant des zones de bits de données correspondant au nombre de bits de données à stocker et stockant une pluralité de bits de données ; et
   une zone tampon (30) qui est contiguë à la zone de stockage de données et le stockage, selon besoin, des données déplacées à l'extérieur de la zone de stockage de données pendant un mouvement de domaine magnétique.

7. Dispositif de mémoire selon la revendication 6, comprenant en outre une deuxième partie d'entrée (40) connectée électriquement au moins l'une des zones de bits de données de la piste de mémoire, et à la couche de référence, et l'entrée d'au moins l'un d'un signal de courant d'écriture et d'un signal de courant de lecture.

8. Dispositif de mémoire selon la revendication 7, dans lequel la piste de mémoire comprend une pluralité de zones de stockage de données (20), une zone tampon (30) est située entre deux zones de stockage de données contiguës, et au moins une deuxième partie d'entrée est formée par zone de stockage de données.

9. Dispositif de mémoire selon l'une quelconque des revendications 1 à 6, comprenant en outre une deuxième partie d'entrée (40) connectée électriquement au moins l'une des zones de bits de données (20) de la piste de mémoire, et à la couche de référence (15), et l'entrée d'au moins l'un d'un signal de courant d'écriture et d'un signal de courant de lecture.

FIG. 1

FIG. 2

FIG. 3

FIG. 4

## FIG. 5A

## FIG. 5B

## FIG. 5C

# FIG. 6A

# FIG. 6B

## FIG. 7

## FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20040251232 A

### Non-patent literature cited in the description

- **Chun et al.** Magnetization switching and tunnelling magnetoresistance effects of synthetic antiferromagnetic free layers consisting of amorphous NiFeSiB. *Applied Physics Letters,* 2005, vol. 87